(19) Europäisches Patentamt / European Patent Office / Office européen des brevets

(11) **EP 1 983 572 A1**

(12) **EUROPEAN PATENT APPLICATION**

(43) Date of publication:
**22.10.2008 Bulletin 2008/43**

(51) Int Cl.:
*H01L 27/02* (2006.01)    *H03F 1/52* (2006.01)

(21) Application number: **07106538.7**

(22) Date of filing: **19.04.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicants:
• **INTERUNIVERSITAIR MICROELEKTRONICA CENTRUM VZW**
  **3001 Leuven (BE)**
• **VRIJE UNIVERSITEIT BRUSSEL**
  **1050 Brussel (BE)**

(72) Inventors:
• **Borremans, Jonathan**
  **B-2500, Lier (BE)**
• **Linten, Dimitri**
  **B-3190, Boortmeerbeek (BE)**
• **Wambacq, Piet**
  **B-1702, Groot-Bijgaarden (BE)**

(74) Representative: **Sarlet, Steven Renaat Irène**
**Gevers & Vander Haeghen**
**Holidaystraat, 5**
**1831 Diegem (BE)**

(54) **Transformer based ESD protection**

(57)    A method for co-designing an electrostatic discharge protection circuit with an analog circuit is presented. The analog circuit comprises a plurality of functional components with predetermined electric properties for achieving a predetermined analog performance. At least one of said functional components is an inductor. The method comprises the steps of coupling an ESD inductor with said inductor such that an ESD transformer is formed providing ESD protection to said analog circuit. The inductors are preferably designed in a common area, for example on top of each other or interleaved. Further, analog circuits designed according to the method are presented, for example a low noise amplifier, a power amplifier and an oscillator.

Fig.2

EP 1 983 572 A1

## Description

### Field of the invention

The invention relates to electrostatic discharge (ESD) protected circuits such as RF circuitry and the method for designing such circuits.

### State of art

Integrated designs in deep-submicron CMOS require ESD protection for their I/O pins. For scaled CMOS such as 45 nm and below, the oxide breakdown voltage decreases as the gate oxide becomes thinner. As a consequence, a classical dual-diode ESD protection requires larger input diodes lowering the diode turn-on resistance sufficiently to obtain the necessary ESD protection level. This increases the parasitic diode capacitance and narrows the design window for RF circuit designers significantly.

There are two approaches to implement ESD protection elements: co-design and plug&play design. In the plug&play design approach, one designs a separate block comprising elements which meet with the desired ESD performance and plug it to the analog circuit. In the co-design approach, the circuit that needs to be protected and the ESD elements are modeled together. Both the ESD and analog characteristics are taken into account.

Inductor and transformer-based ESD protection have been suggested [S. Galal, B. Razavi, '40-Gb/s Amplifier and ESD protection circuit in 0.18$\mu$m CMOS technology', JSSI, Vol.39, No.12, December 2004], [D. Linten et al., 'An integrated 5GHz low-noise amplifier with 5.5kV HBM ESD protection in 90nm RF CMOS', VLSI Circuits Symposium, June 2005, pp. 86-89]. These solutions add inductors or transformers to the circuit's input to offer adequate ESD protection while maintaining design freedom.

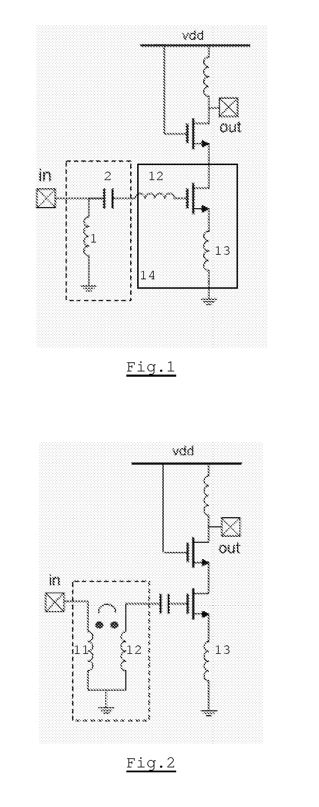

An example to protect a low noise amplifier (LNA) from ESD is shown in fig.1. An inductive ESD protection consists of an inductor $L_{ESD}$ (1) sinking the low-frequency ESD currents (below 1 GHz) to ground, preventing the vulnerable gate of the input transistor to be damaged. A series capacitor $C_{ESD}$ (2) passes the RF signal at the LNA's operating frequency. This technique has proven to offer excellent protection (more than 2 kV HBM in 90 nm RF CMOS). For very high ESD currents, however, a residual voltage overshoot is passed on to the gate via $C_{ESD}$, and the input transistor fails. This can be prevented by adding tiny clamping diodes at the gate, clipping small voltage overshoots and increasing the protection level above 5 kV HBM.

### Aim of the invention

It is an aim of the invention to provide ESD protection to an analog circuit which occupies less area.

### Summary of the invention

A method for co-designing an electrostatic discharge (ESD) protection circuit with an analog circuit is presented. The analog circuit comprises a plurality of functional components with predetermined electric properties for achieving a predetermined analog performance. At least one of the functional components is an inductor. The method comprises the steps of coupling an ESD inductor with the inductor such that an ESD transformer is formed providing ESD protection to the analog circuit. By coupling the ESD inductor with an existing inductor, ESD protection can be provided without area penalty. An analysis of the prior art has shown techniques where extra inductors are added to the circuitry. Inductors have the disadvantage that they are hard to scale down. Therefore these techniques suffer a severe area penalty. This is undesirable in expensive downscaled CMOS.

In a preferred embodiment, the inductor is present at the input or at the output of the analog circuit.

In a preferred embodiment, the inductors forming the ESD transformer are designed within a common area. The ESD inductor can for example be designed on top of the inductor of the analog circuit. In another example, the inductors are interwinded. In this way, substantially no area is added to the circuit by the ESD protection. Furthermore, a galvanic separation is realized between the input and the actual input of the analog circuit, heavily attenuating the possible residual voltage overshoot at the input for the ESD frequency range, and thus increasing the protection level.

Further, the method for co-designing an ESD protection preferably comprises the step of selecting the properties of the ESD inductor such that influence on the predetermined analog performance during normal operation is minimized.

In a preferred embodiment, the analog circuit is a low noise amplifier (LNA) wherein the inductor is represented by an LNA input inductor. According to the invention, an LNA can be designed with ESD protection substantially without area penalty which is an important asset in deep-submicron CMOS design.

In another preferred embodiment, the analog circuit is a power amplifier. The power amplifier has a resonant load comprising an inductor. A transformer coupling creates a matching network for the off chip load, and functions as ESD protection via an ESD inductor.

In another preferred embodiment, the analog circuit is an oscillator. This oscillator is preferably a power oscillator based on an LC resonant LOAD, comprising an inductor. An oscillation signal can be brought off chip using a transformer coupling. This transformer forms both the resonant tank for oscillation, the matching network to drive the off-chip output load, and serves as ESD protection circuit via an ESD inductor.

The analog circuit designed according to the invention comprises in combination a plurality of interconnected functional components with predetermined electric properties for achieving a predetermined analog performance during normal operation of the circuit. At least one of the functional components is an inductor. This inductor is preferably present at the input or at the output of the analog circuit. Further, an ESD inductor is coupled to this inductor forming an ESD transformer providing ESD protection to the circuit.

In a preferred embodiment, the circuit is a low noise amplifier circuit. The circuit comprises a first transistor. This transistor has a source, a drain, a gate, and a gate oxide separating the gate from the source and the drain. This transistor is one of the functional components of the circuit. Further, an LNA input inductor is connected to the gate of the transistor (or gate inductor). An ESD inductor is coupled with the LNA input inductor such that an ESD transformer is formed providing ESD protection to avoid breakdown at said gate oxide during an ESD event.

In another preferred embodiment, the circuit can be a power amplifier. The circuit comprises a transistor having a source, a drain, a gate and a gate oxide separating the gate from the source and the drain. This transistor forms one of the functional components of the circuit. The power amplifier comprises a resonant load which comprises a power amplifier output inductor connected with the drain of the transistor. An ESD inductor is being coupled with this power amplifier output inductor such that an ESD transformer is formed providing ESD protection to avoid breakdown at the output of said power amplifier during an ESD event.

In another preferred embodiment, the circuit can be an oscillator. The circuit comprises a transistor having a source, a drain, a gate and a gate oxide separating the gate from the source and the drain. This transistor forms one of the functional components of the circuit. The oscillator comprises an LC resonant load comprising an oscillator inductor which is being connected with the drain of the transistor. An ESD inductor is coupled with the oscillator inductor such that an ESD transformer is formed providing ESD protection to avoid breakdown at the output of the oscillator during an ESD event.

### Brief description of the drawings

These and other features, aspects and advantages of the present invention will become better understood with regard to the following description, appended claims, and accompanying drawings here.

Fig.1 shows a classical inductor-based ESD protection.

Fig.2 shows an example of the proposed low-area transformer-based ESD protection applied in an LNA.

Fig.3 shows an Equivalent LNA input network referred to the secondary side, for a high k-value.

Fig.4 shows transformer geometry.

Fig.5 represents schematic a chip micrograph.

Fig.6 shows a plot of the measured S-parameters.

Fig.7 shows a plot of the noise figure.

Fig.8 shows an example of the proposed low-area transformer-based ESD protection applied in a power amplifier.

Fig.9 shows an example of the proposed low-area transformer-based ESD protection applied in an oscillator.

### Detailed description of the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes.

An analysis of the prior art techniques have shown techniques where extra inductors are added to the circuitry. Inductors have the disadvantage that they are hard to scale down. Therefore these techniques suffer a severe area penalty. This is undesirable in expensive downscaled CMOS.

The present invention relates to a method for co-designing an electrostatic discharge (ESD) protection circuit with an analog circuit. The analog circuit comprises at least one functional inductor at the input or output. Possible examples of analog circuits containing such inductor at the input or the output are a LNA, a power amplifier and an oscillator.

The method comprises the step of coupling a second inductor or ESD inductor with the inductor present at the input and/or at the output of the circuit. By coupling both inductors, a transformer is formed.

The ESD inductor is shifted physically 'under' the inductor present (or placed above the inductor). The benefit is twofold. First, there is no area penalty for the ESD protection. Secondly, a galvanic separation is realized between the input and the actual input of the analog circuit, heavily attenuating the possible residual voltage overshoot at the input for the ESD frequency range, and thus increasing the protection level.

In fig.2, the present invention is exemplified by means of a LNA. The ESD inductor, $L_1$ (**11**) is shifted under the gate inductor $L_G$ (**12**) already present, forming a transformer with coupling coefficient k.

For large coupling coefficients k, the transformer resonates with the inductor $L_S$ (**13**) and the transistor capacitance $C_{gs}$ (**31**) at a pulsation of:

$$\omega_0 = \frac{1}{\sqrt{\left(L_1 + \frac{L_S}{n^2}\right) \cdot n^2 C_{gs}}}$$

with $n = k\sqrt{\frac{L_G}{L_1}}$ At resonance, the input impedance is approximately

$$Z_{IN} \approx \frac{\omega_T L_S}{n^2}$$

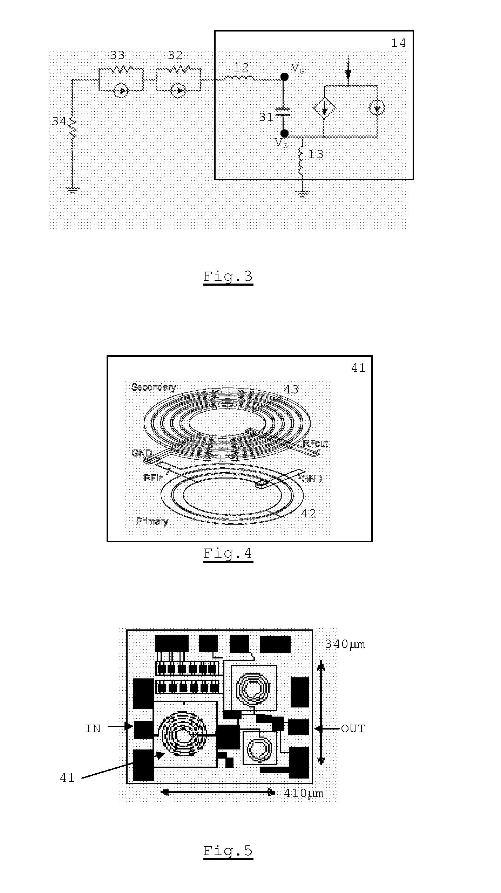

To calculate the impact on the noise figure, a series to parallel conversion is applied on the secondary side of the transformer. Fig.3 shows an equivalent LNA input network referred to the secondary side, for a high *k*-value. An equivalent of the primary side of the transformer, respectively secondary is represented by (33), respectively (**32**). Both blocks comprise a parasitic resistance, $n^2R_1$ respectively $R_2$, and a noise current, $I_{n,R1}$ respectively $I_{n,R2}$. The parasitic resistance (**34**) equals $n^2R_S$. The right block of fig.3 represents the equivalent network of the transistor (**14**) of fig.1. The method used for the noise analysis can be found in D.K. Shaeffer, T.H. Lee, 'A 1.5-V, 1.5-GHz CMOS low noise amplifier', JSSC, vol.32, no.5, pp.745-759, May 1997. The selection of values of the passives will differ due to the transformer, but the mechanisms to minimize the noise are the same. The noise contribution of the transformer replaces the contribution of the primary inductor in the noise analysis method and contributes as an extra term $F_{EXTRA}$:

$$F_{EXTRA} = \frac{R_1}{R_S} + \frac{R_2}{n^2 R_S}$$

The contribution of the secondary of the transformer is reduced by the square of the turn ratio n. A high turn ratio is thus beneficial to reduce the noise contribution, but increases the power needed to realize input matching because

$$Z_{IN} \approx \frac{\omega_T L_S}{n^2} .$$

These observations are valid for a high value of the coupling coefficient k. In modern CMOS technologies, *k*-values up to 0.9 can be achieved [J. Long,'Monolithic Transformers for Silicon RF IC Design', JSSC, vol.35, no.9, pp. 1368-1382, Sept.2000].

The circuit has been designed for 5-6 GHz operation in a 0.13 $\mu$m CMOS technology. During design a trade-off has been made between noise degradation, minimum resistance in the ESD path, and acceptable power consumption.

The transformer (**41**) is shown in fig.4. It is designed as two inductors on top of each other, a primary (**42**) and secondary inductor (**43**). This eases the desired turn ratio n selection. A turn ratio n of 1.6 and a coupling factor k of 0.82 are achieved. The secondary is designed in the lowest resistance metal layer (M8: top metal) with an aluminum (Al) overpass. The Al layer (1.5 $\mu$m thick) is used as a capping layer for bondpads or for connecting the MiM-capacitors and is suitable for partial inductor layouting.

The primary inductor (lowest number of turns) is drawn in metal 7 (M7) with M6 underpass. Its tracks are wider for low parasitic resistance and to achieve a similar resonance frequency as the secondary.

The selection of these layers minimizes the noise contribution. To minimize corner effects, a circular inductor shape is chosen.

Fig.5 shows a chip micrograph. The circuit only occupies the area needed by the three inductors present in a standard LNA design.

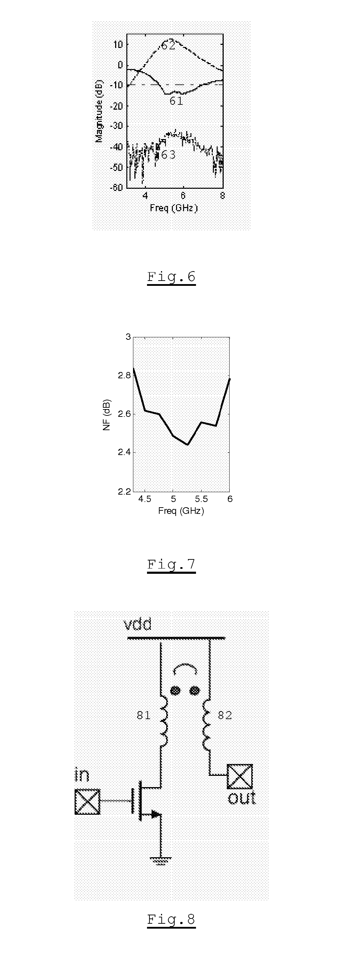

Fig.6 shows the measured S-parameters of the LNA. The circuit has a return loss $S_{11}$ (**61**) below -10 dB and offers 12 dB power gain (**62**), driving 50 $\Omega$ via a tapped capacitor output match. On-wafer HBM measurements reveal an excellent ESD protection level of more than 8 kV positive and 5 kV negative for the input.

The noise figure plotted in fig.7 is very respectable especially given the extremely high ESD protection level and the low area consumption. These demands - usually conflicting - are reconciled by the present invention proposed technique. The measured IIP3 of the LNA is -9 dBm.

Table 1 compares the results of the present invention to the state-of-the-art of fully integrated ESD protected CMOS LNAs (no off-chip components). The present invention offers the best RF performance for excellent ESD protection and compact area.

Table 1 - Overview of fully integrated ESD protected LNAs

| | **Present invention** | **[1]** | **[2]** |
|---|---|---|---|
| **Technology (CMOS)** | .13$\mu$m | 90nm | .18$\mu$m |
| **$f_0$ (GHz)** | 5.5 | 5 | 5.25 |
| **NF (dB)** | 2.5 | 3.4 | 3.12 |
| **Power (mW)** | 6.6 | 9 | 10.8 |
| **Gain (dB)** | 12.4 | 12 | 12.41 |
| **IIP3 (dBm)** | -9 | 0.4 | -14.6 |
| **HBM protection (kV)** | **5** | 5.5 | ~3.4 (5.1 A TLP) |
| **Approx. area (mm$^2$)** | **0.14** | ~0.8 | - |
| [1] D. Linten et al., 'An integrated 5GHz low-noise amplifier with 5.5kV HBM ESD protection in 90nm RF CMOS', VLSI Circuits Symposium, June 2005, pp.86-89. [2] S. Hyvonen, E. Rosenbaum, 'Diode-based tuned ESD protection for 5.25GHz CMOS LNA's', EOS/ESD Symposium, Sept.2005, pp.9-17. | | | |

Another application is a power amplifier or a resonant output buffer, shown in fig.8. An amplifier with a resonant load including $L_1$ (**81**) amplifies the signal at node IN. A transformer coupling creates a matching network for the off chip load, and functions as ESD protection via $L_2$ (**82**). Thus $L_2$ serves both as RF and ESD protection device.

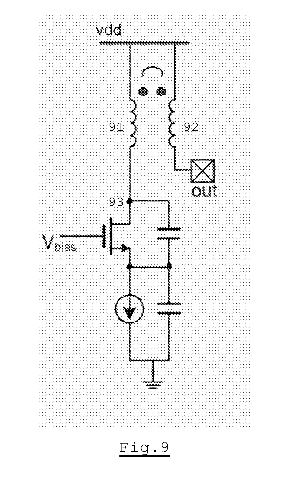

Fig.9 shows another application, a power oscillator based on an LC resonant LOAD, comprising an inductor $L_1$ (**91**). An example is the Collpits oscillator. An oscillation is present at node $V_{osc}$ (**93**). This signal can be brought off chip using a transformer coupling. This transformer forms both the resonant tank for oscillation, the matching network to drive the off-chip output load, and serves as ESD protection via $L_2$ (**92**).

**Claims**

1. A method for co-designing an electrostatic discharge protection circuit with an analog circuit,

   - said analog circuit comprising a plurality of functional components with predetermined electric properties for achieving a predetermined analog performance,
   - at least one of said functional components being an inductor (12),
   - the method comprising the steps of coupling an ESD inductor (11) with said inductor such that an ESD transformer is formed providing ESD protection to said analog circuit.

2. A method according to claim 1, **characterised in that** said inductor (12) is an input/output inductor.

3. A method according to any of the previous claims, **characterised** that said inductors are designed within common area (41) .

4. The method according to any of the previous claims, **characterised** that the properties of said ESD inductor are chosen such that influence is minimized on said predetermined analog performance during normal operation.

5. A method according to any of the previous claims **characterised in that** said analog circuit is a low noise amplifier wherein said inductor is represented by an LNA input inductor (12).

6. A method according to any of claims 1-4 **characterised in that** said analog circuit is a power amplifier wherein said inductor is represented by a power amplifier output inductor (81).

7. A method according to any of claims 1-4 **characterised in that** said analog circuit is an oscillator (LC) wherein said inductor is represented by an oscillator inductor (91).

8. An analog circuit, comprising in combination:

   - a plurality of interconnected functional components with predetermined electric properties for achieving a predetermined analog performance during normal operation of the circuit;
   - at least one of said functional components being an inductor (12); and
   - an ESD inductor (11) coupled to said inductor forming a transformer providing ESD protection to said analog circuit.

9. The analog circuit according to claim 8, **characterised in that** said inductor (12) is an input/output inductor of said analog circuit.

10. The analog circuit according to any of claims 8-9, wherein the circuit is a low noise amplifier circuit for RF signals comprising:

   - a first transistor having a source, a drain, a gate and a gate oxide separating the gate from the source and the drain, wherein the first transistor forms one of the functional components of said circuit;
   - an LNA input inductor (12) being connected with the gate of said first transistor; and
   - an ESD inductor (11) being coupled with said LNA input inductor such that an ESD transformer is formed providing ESD protection to avoid breakdown at said gate oxide during an ESD event.

11. The analog circuit according to any of claims 8-9, wherein the circuit is a power amplifier comprising:

   - a second transistor having a source, a drain, a gate and a gate oxide separating the gate from the source and the drain, wherein the second transistor forms one of the functional components of said circuit;
   - a resonant load comprising a power amplifier output inductor (81) connected with the drain of said second transistor; and
   - an ESD inductor (82) being coupled with said power amplifier output inductor such that an ESD transformer is formed providing ESD protection to avoid breakdown at the output of said power amplifier during an ESD event.

12. The analog circuit according to any of claims 8-9, wherein the circuit is an oscillator comprising:

   - a third transistor having a source, a drain, a gate and a gate oxide separating the gate from the source and the drain, wherein the third transistor forms one of the functional components of said circuit;
   - an LC resonant load comprising an oscillator inductor (91) being connected with the drain of said third transistor; and
   - an ESD inductor (92) being coupled with said oscillator inductor such that an ESD transformer is formed providing ESD protection to avoid breakdown at the output of said oscillator during an ESD event.

Fig.1

Fig.2

Fig.3

Fig.4

Fig.5

Fig.6

Fig.7

Fig.8

Fig.9

**European Patent Office**

**EUROPEAN SEARCH REPORT**

Application Number

EP 07 10 6538

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/135026 A1 (KHORRAM SHAHLA [US]) 23 June 2005 (2005-06-23) * abstract * * paragraphs [0034] - [0040] * * figures 5-7 * | 1-12 | INV. H01L27/02 H03F1/52 |
| X | GALAL S ET AL: "Broadband esd protection circuits in cmos technology" IEEE JOURNAL OF SOLID-STATE CIRCUITS, IEEE SERVICE CENTER, PISCATAWAY, NJ, US, vol. 38, no. 12, December 2003 (2003-12), pages 2334-2340, XP011104275 ISSN: 0018-9200 Section "III T-Coil Networks in Broadband Design" | 8-12 | |
| A | | 1-7 | |
| A | US 3 587 017 A (KURUSU MICHIO) 22 June 1971 (1971-06-22) * abstract * * column 5, line 32 - column 7, line 6 * * figures 7-15 * | 1-12 | TECHNICAL FIELDS SEARCHED (IPC) H01L H03F |
| A | US 2002/149425 A1 (CHAWLA YOGENDRA K [US] ET AL) 17 October 2002 (2002-10-17) * abstract * * paragraphs [0045], [0046] * * figures 1,2 * | 1-12 | |

-/--

The present search report has been drawn up for all claims

| Place of search | Date of completion of the search | Examiner |
|---|---|---|
| Berlin | 25 September 2007 | Morena, Enrico |

EPO FORM 1503 03.82 (P04C01)

**European Patent Office**

**EUROPEAN SEARCH REPORT**

Application Number

EP 07 10 6538

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JANSEN PH ET AL: "RF ESD protection strategies - the design and performance trade-off challenges" CUSTOM INTEGRATED CIRCUITS CONFERENCE, 2005. PROCEEDINGS OF THE IEEE 2005 SAN JOSE, CA, USA SEPT. 18-21, 2005, PISCATAWAY, NJ, USA,IEEE, 18 September 2005 (2005-09-18), pages 484-491, XP010873571 ISBN: 0-7803-9023-7 * abstract * Section: "VI Protection Strategy 3 (Full Circuit ESD Co-Design)" ----- | 1-12 | |
| | | | **TECHNICAL FIELDS SEARCHED (IPC)** |

The present search report has been drawn up for all claims

| Place of search | Date of completion of the search | Examiner |
|---|---|---|
| Berlin | 25 September 2007 | Morena, Enrico |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                                                                       
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 10 6538

This annex lists the patent family members relating to the patent documents cited in the above-mentioned European search report.
The members are as contained in the European Patent Office EDP file on
The European Patent Office is in no way liable for these particulars which are merely given for the purpose of information.

25-09-2007

| Patent document cited in search report | | Publication date | Patent family member(s) | Publication date |
|---|---|---|---|---|
| US 2005135026 | A1 | 23-06-2005 | NONE | |
| US 3587017 | A | 22-06-1971 | NONE | |
| US 2002149425 | A1 | 17-10-2002 | NONE | |

EPO FORM P0459

For more details about this annex : see Official Journal of the European Patent Office, No. 12/82

**EP 1 983 572 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **S. GALAL ; B. RAZAVI.** 40-Gb/s Amplifier and ESD protection circuit in $0.18\mu$m CMOS technology. *JSSI,* December 2004, vol. 39 (12
- **D. LINTEN et al.** An integrated 5GHz low-noise amplifier with 5.5kV HBM ESD protection in 90nm RF CMOS. *VLSI Circuits Symposium,* June 2005, 86-89
- **D.K. SHAEFFER ; T.H. LEE.** A 1.5-V, 1.5-GHz CMOS low noise amplifier. *JSSC,* May 1997, vol. 32 (5), 745-759
- **J. LONG.** Monolithic Transformers for Silicon RF IC Design. *JSSC,* September 2000, vol. 35 (9), 1368-1382
- **S. HYVONEN ; E. ROSENBAUM.** Diode-based tuned ESD protection for 5.25GHz CMOS LNA's. *EOS/ESD Symposium,* September 2005, 9-17